(19) Europäisches Patentamt
European Patent Office
Office européen des brevets

(11) Publication number: **0 106 152 B1**

(12) **EUROPEAN PATENT SPECIFICATION**

(45) Date of publication of patent specification: **09.08.89**

(51) Int. Cl.[4]: **H 01 S 3/19**

(21) Application number: **83108998.2**

(22) Date of filing: **12.09.83**

# (54) Semiconductor laser device.

(30) Priority: **13.09.82 JP 158136/82**

(43) Date of publication of application:
**25.04.84 Bulletin 84/17**

(45) Publication of the grant of the patent:
**09.08.89 Bulletin 89/32**

(84) Designated Contracting States:
**DE FR GB NL**

(58) References cited:
**EP-A-0 020 019**
**EP-A-0 025 362**
**GB-A-2 031 644**
**US-A-4 328 469**

**IEEE JOURNAL OF QUANTUM ELECTRONICS, vol.QE-11, no. 7, July 1975, pages 494-498, IEEE, New York, US; T. TSUKADA et al.: "Thermal characteristics of buried-heterostructure injection lasers"**

(73) Proprietor: **HITACHI, LTD.**
**6, Kanda Surugadai 4-chome Chiyoda-ku**
**Tokyo (JP)**

(72) Inventor: **Kuroda, Takao**
**4-14-6, Nishi-koigakubo**
**Kokubunji-shi Tokyo (JP)**
Inventor: **Kajimura, Takashi**
**2196-251, Hirai Hinodemachi**
**Nishitama-gun Tokyo (JP)**
Inventor: **Kashiwada, Yasutoshi**
**2196-448, Hirai Hinodemachi**
**Nishitama-gun Tokyo (JP)**
Inventor: **Chinone, Naoki**
**1-47-3-F202, Akatsuki-cho**
**Hachioji-shi Tokyo (JP)**
Inventor: **Ouchi, Hirobumi**
**2-12-10. Shinmei**
**Hino-shi Tokyo (JP)**
Inventor: **Ohtoshi, Tsukuru**
**2-21-25, Fujimoto**
**Kokubunji-shi Tokyo (JP)**

(74) Representative: **Strehl, Peter, Dipl.-Ing. et al**
**Patentanwälte Strehl Schübel-Hopf Groening Schulz Maximilianstrasse 54 Postfach 22 14 55**
**D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 106 152 B1

(56) References cited:
IEEE JOURNAL OF QUANTUM ELECTRONICS, vol.QE-14, no. 2, February 1978, pages 89-94, IEEE, New York, US; K. AIKI et al.: "Transverse mode stabilized AlxGa1-xAs injection lasers with channeled-substrate-planar structure"

**Description**

The present invention relates to semiconductor laser devices, and more particularly to a semiconductor laser device which oscillates in a single longitudinal mode.

The so-called BH (Buried Hetero) type or CSP (Channeled Substrate Planar) type laser, which is a typical example of a semiconductor laser of the index-guided type, exhibits a good "optical output-versus-current" characteristic and is free from astigmatism, and is therefore used as a pickup light source for an optical disk. The laser presents a single longitudinal mode oscillation in which most of its optical output concentrates in a single longitudinal mode, and which corresponds to a spectrum as shown in Figure 1 by way of example. It has been revealed, however, that when the ambient temperature has changed, a plurality of longitudinal modes oscillate simultaneously and cause severe noise in some devices, so the control and readout of the optical disk are hampered.

The CSP laser is reported in detail in:

(1) IEEE Journal of Quantum Electronics, vol. QE-14, No. 2, Feb. 1978, pp. 89—94,

(2) J. Appl, Phys. 49(9), Sept. 1978, pp. 4644—4648, etc.

The BH laser is introduced by:

IEEE Journal of Quantum Electronics, vol. QE-11, No. 7, July 1975, etc.

An object of the present invention is to provide a semiconductor laser device which oscillates in a single longitudinal mode and which is free from the noise as stated above.

The present invention consists in improvements in a semiconductor laser of a conventional double heterostructure, namely, a semiconductor laser having at least a first semiconductor layer, and second and third semiconductor layers which hold the first semiconductor layer therebetween and which are greater in the band gap and smaller in the refractive index than the first semiconductor layer. Usually, the oscillation in a single longitudinal mode is realized by employing the index-guided type as the guide setup of an active region. Ordinarily, the second and third semiconductor layers have opposite conductivity types. The relationship between the donor concentration $N_D$ is (given in $10^{17}$ $cm^{-3}$) of the semiconductor layer having the n-conductivity type in the second and third semiconductor layers of such semiconductor laser and the proportion $\Gamma_n$ (given in %) of the optical output existing in the particular semiconductor layer relative to the total optical output of the laser is set at:

$$N_D \cdot \Gamma_n \geq 500 \quad (1)$$

whereby the aforementioned object can be accomplished.

As a donor impurity, Te (tellurium) which develops a deep level exhibitive of saturable optical absorption is the most useful.

In the accompanying drawings:

Figure 1 shows a typical longitudinal mode spectrum distribution of an index-guided type semiconductor laser device which oscillates in a single longitudinal mode;

Figure 2 is a graph showing a typical example of the temperature dependency of the oscillation wavelength observed in a semiconductor laser device in which a single longitudinal mode oscillation is stabilized;

Figure 3 is a model diagram for explaining the concept of the proportion of a light distribution existent in a clad layer;

Figure 4 is a perspective view of a CSP type laser device;

Figure 5 is a graph showing the relationship between the loss difference $\Delta\alpha$ and the cavity length;

Figure 6 is a graph showing the relationship between the loss difference and the width of the active layer;

Figure 7 is a sectional view showing an index-guided type semiconductor laser device whose active layer is curved;

Figure 8 is a graph showing the relationship between $N_D \cdot \Gamma_n$ and the available percentage of low noise devices;

Figure 9 is a graph showing the temperature dependency of the percentage of low noise laser devices; and

Figure 10 is a graph showing the temperature dependency of RIN (relative intensity noise).

As stated before, the object of the present invention is achieved by setting the relationship between the donor concentration $N_D$ (given in $10^{17}$ $cm^{-3}$) of the semiconductor layer having the n-conductivity type in the second or third semiconductor layer of the semiconductor laser and the proportion $\Gamma_n$ (given in %) of the optical output existing in the particular semiconductor layer relative to the total optical output of the laser, at $N_D \cdot \Gamma_n \geq 500$.

The principle is interpreted as follows. Deep trap levels exhibitive of saturable optical absorption, called DX centers (Donor Complex Centers), are developed in a sutiable amount within the n-conductivity type clad layer of the semiconductor laser, whereupon a suitable proportion of the total optical output is caused to exist within the n-conductivity type clad layer. Under such conditions, the difference $\Delta\alpha$ of absorption losses arises along a longitudinal mode which oscillates and the other non-oscillating longitudinal modes, and the longitudinal modes other than the oscillating longitudinal mode suffer heavier losses, so that the oscillation in the single longitudinal mode is stabilized. Further, a hysteresis as shown in Figure 2 constributes to the temperature variation of the longitudinal mode. Only the mode of one wavelength can rise at an identical temperature, and the longitudinal mode is stabilized. It is considered that, as the loss difference $\Delta\alpha$ is greater, the longitudinal mode will become more difficult to vary against temperature changes, and noise arising due to the longitudinal mode variation attributed to temperature fluctuations will decrease more. Figure 2 depicts small hysteresis characteristics with temperature differences of one degree odd, and the above-stated influence of the changes of the ambient temperature on the mode concerns such extent of temperature differences.

Usually, in case of doping a semiconductor layer with a donor impurity, the density of DX centers is substantially proportional to the donor density $N_D$. Accordingly, letting $\Gamma_n$ denote the percentage of the light distribution existing in the n-clad layer, the loss difference $\Delta\alpha$ has the following relationship:

$$\Delta\alpha \sim N_D \cdot \Gamma_n. \qquad (2)$$

Using a three-layer waveguide line model, $\Gamma_n$ is calculated in accordance with a formula mentioned below. Figure 3 is a diagram showing this model, in which $n_2$, $n_3$ and $n_4$ indicate the refractive indicies of the respective layers. In the figure, numeral 2 designates a clad layer of the n-conductivity type, numeral 3 an active layer, and numeral 4 a clad layer of the p-conductivity type. $\Gamma_n$ denotes the percentage of the light distribution existing in the n-clad layer.

$$\Gamma_n = \frac{\int_{-\infty}^{-d_3/2} E_{y2}^2 dx}{\int_{-\infty}^{-d_3/2} E_{y2}^2 dx + \int_{-d_3/2}^{d_3/2} E_{y3}^2 dx + \int_{d_3/2}^{\infty} E_{y4}^2 dx}$$

where $E_{y2}$, $E_{y3}$ and $E_{y4}$ denote electric field intensities in the respecitve layers 2, 3 and 4. $d_3$ denotes the thickness of the active layer 3.

The electric field intensities $E_{y2}$, $E_{y3}$ and $E_{y4}$ in the above formula giving the proportion $\Gamma_n$ can be determined by solving characteristic equations whose parameters are the oscillation wavelength ($\lambda$) of the laser, the thickness ($d_3$) of the active layer and the refractive indices $n_2$, $n_3$ and $n_4$ of the respective layers. In addition, the indices $n_2$, $n_3$ and $n_4$ can be evaluatd from the wavelength ($\lambda$) and the AlAs mole fractions of the respective layers. This is explained in, e.g., M. A. Afromowitz: Solid State Commun. *15* (1974) 59.

The fundamental idea of such waveguide line model is as explained in, e.g., "Semiconductor Lasers and Heterostructure LEDS, HENRY KRESSEL et al, ACADEMIC PRESS, New York 1977', pp. 148—150.

The aforementioned relationship can be set by various methods as stated below.

The adjustment of the donor density is, of course, made by adjusting the quantity of doping with a donor impurity. The upper limit of the donor density is on the order of $2\times10^{18}$ $cm^{-3}$ in view of the occurrence of lattice defects, etc.

Further, the adjustment of $\Gamma_n$ can be made by adjusting the thickness of the active layer, changing the ratios of the mole fractions of the two clad layers holding the active layer therebetween, etc. Besides, the loss difference $\Delta\alpha$ has dependencies upon the cavity length *l* of the laser and the width of a light emitting region, i.e., the width *w* of the active region. Figure 4 shows how to take *l* and *w* by way of example. It exemplifies an index-guided type semiconductor laser which is usually termed a CSP (Channeled Substrate Planar type) laser.

In Figure 4, numeral 1 designates a semiconductor substrate, numerals 2 and 4 clad layers, numeral 3 an active layer, and numeral 5 a cap layer. The index-guided structure is realised by utilizing the difference of effective refractive indices produced by the ruggedness of the clad layers.

Figures 5 and 6 illustrate the relationship between the cavity length (*l*) and the loss difference and the relationship between the width of the active region and the loss difference, respectively.

It is understood from Figure 5 that the loss difference presents a curve which has maximum values at some values of *l*. It is also understood from Figure 6 that the loss difference $\Delta\alpha$ becomes greater as the active region width *w* is smaller. In the present invention, accordingly, it is more favorable to set the product $N_D \cdot \Gamma_n$ at or above 500 ($\times10^{17}$ $cm^{-3} \cdot \%$) and to simultaneously optimize the laser cavity length *l* and the active region width *w* to the end of increasing the loss difference $\Delta\alpha$. Results in Figure 5 were obtained as to examples in each of which the thickness $d_3$ of the active layer was 0.06 μm, the width *w* of the active layer was 4 μm and the $N_D$ carrier concentration was $1\times10^{18}$ $cm^{-3}$. Regarding n/p clad compositions, when $Ga_{1-x}Al_xAs$ denotes the composition of each clad layer, the ratio between the mole fraction (x) of the n-conductivity type clad layer and that (x') of the p-conductivity type clad layer is indicated. Results in Figure 6 were obtained as to examples in each of which the thickness of the active layer was 0.06 μm, the cavity length was 300 μm and the $N_D$ carrier concentration was $1\times10^{18}$ $cm^{-3}$.

In both Figures 5 and 6, the structure in which the mole fraction of the p-type clad layer is greater than that of the n-type clad layer has a greater loss difference $\Delta\alpha$ as compared with the structure in which the mole fractions of both the layers are equal. The reason is that, in the former structure, the refractive index $n_4$ in Figure 3 becomes smaller than $n_2$, so the light distribution shifts toward the n-type clad layer to increase $\Gamma_n$.

Embodiments

Now, the present invention will be described in detail with reference to embodiments thereof.

In an AlGaAs-based visible semiconductor laser having an oscillation wavelength of 780 nm, the CSP type structure shown in Figure 4 was used as the index-guided type structure oscillating in a single longitudinal mode. On the (100) face of an n-type GaAs substrate 1 (doped with Si, $n \sim 1\times10^{18}$ $cm^{-3}$), a photoresist film having a window was formed by a conventional photoresist process. By performing chemical etching through the window, a recess about 1 μm deep was formed in the substrate 1. After removing the photoresist film, a Te-doped $n-Al_xGa_{1-x}As$ clad layer 2 ($0.4 \leq x \leq 0.45$), an undoped $Al_yGa_{1-y}As$ active layer 3 ($y \sim 0.14$, corresponding to the oscillation wavelength of 780 nm), a Zn-doped $p-Al_zGa_{1-z}As$ clad layer 4 ($0.4 \leq z \leq 0.5$, $p \sim 5\times10^{17} cm^{-3}$), and a Te-doped n-GaAs cap layer 5 ($n \sim 1\times10^{18} cm^{-3}$) were formed on the substrate by the well-known continuous liquid epitaxy. At this time, the thickness of the active layer 3 was 0.04—0.07 μm, the thickness of the n-clad layer 2 was 1.3 μm at the middle part of the recess and 0.3 μm on both the sides of the recess, the thickness of the p-clad layer 4 was 1.5 μm, and the thickness of the cap layer 5 was 1 μm. Table 1 lists up examples of the semiconductor laser manufactured by way of trial.

TABLE 1

| No. | | 1 | 2 | 3 | 4 | 5 |
|---|---|---|---|---|---|---|
| p-clad layer $Ga_{1-x}Al_xAs$ | Thickness (μm) | 2.0 | 2.0 | 2.0 | 2.0 | 2.0 |
| | Mole fraction $x$ | 0.40 | 0.45 | 0.45 | 0.50 | 0.50 |
| | Carrier concentration ($\times10^{17}$ $cm^{-3}$) | 4 | 4 | 1 | 2 | 5 |
| Active layer $Ga_{1-x}Al_xAs$ | Thickness $d_3$ (μm) | 0.047 | 0.060 | 0.040 | 0.046 | 0.058 |
| | Width $w$ (μm) | 4 | 4 | 3 | 3 | 2 |
| | Mole fraction $x$ | 0.14 | 0.14 | 0.14 | 0.14 | 0.14 |
| n-clad layer $Ga_{1-x}Al_xAs$ | Thickness (μm) | 0.4 (1.2)* | 0.4 (1.2) | 0.4 (1.2) | 0.4 (1.2) | 0.4 (1.2) |
| | Mole fraction $x$ | 0.40 | 0.4 | 0.40 | 0.45 | 0.45 |
| | Carrier concentration $N_D$ ($\times10^{17}$ $cm^{-3}$) | 15 | 10 | 15 | 10 | 15 |
| Cavity length (μm) | | 230 | 420 | 230 | 420 | 230 |
| $\Gamma_n$ (%) | | 44 | 57 | 81 | 66 | 54 |
| $N_D \cdot \Gamma_n$ | | 660 | 570 | 1215 | 660 | 810 |

*Values in ( ) indicate the thickness in the recess.

All the examples were excellent in noise characteristics. In addition, Figure 7 shows a structure of the type in which the active layer is curved, as an embodiment corresponding to Figure 2. In this structure, the active layer sags slightly at the middle part of the recess, and the thickness of the active layer at its central part is slightly greater, so that a transverse mode is controlled. Numerals 1—5 in Figure 7 are similar to those in the case of the CSP structure in Figure 4. On the cap layer 5, an $SiO_2$-SiN film was formed by the sputtering evaporation, or an $SiO_2$—$Al_2O_3$ film by the CVD (Chemical Vapor Deposition). Thereafter, via the photoresist process, a diffusion window was provided, through which Zn was diffused to form a p-type Zn-diffused region 6 serving as a current path. Thereafter, Ti—Mo—Au was evaporated as a p-type electrode, and AuGeNi—Cr—Pd—Au as an n-type electrode. Lastly, the crystal was cleaved at the (110) faces so that the opposing faces might become parallel to each other. Then, the laser device was finished up.

Herein, in order to change the DX center density in the n-clad layer, the quantity of doping with Te was changed in a range of 1—$20\times10^{17}$ $cm^{-3}$ in terms of the carrier density $N_D$. Besides, in order to change the percentage $\Gamma_n$ of the optical output in the n-clad layer, the mole ratio (x/z) of AlAs between the n-conductivity type and p-conductivity type clad layers was changed into the four sorts (0.4/0.4), (0.4/0.45), (0.45/0.45) and (0.45/0.50). Further, the thickness *d* of the active layer was changed in a range of 0.04—0.07 µm, whereby $\Gamma_n$ was changed in a range of 40—70%. The noise characteristics of laser devices produced on the basis of the combinations of these values $N_D$ and $\Gamma_n$ were investigated. As a result, it has been revealed that the available percentage of low noise devices is correlated with the product $N_D \cdot \Gamma_n$ very well as illustrated in Figure 8. That is, it has been revealed that, with the devices satisfying $N_D \cdot \Gamma_n \geq 500$, low noise can be realized at the available percentage of 100%. In each of the examples, the width of the active region was 4 µm, and the cavity length was 300 µm. Figure 9 illustrates the temperature dependencies of the percentages of the low noise devices as to the device groups of $N_D \cdot \Gamma_n=400$ and 500 among the devices shown in Figure 8. At high temperatures, the available percentage lowers in correspondence with the fact that the coefficient of light absorption by the DX centers decreases. As regards the devices of $N_D \cdot \Gamma_n \geq 500$, however, it is seen that a high available percentage above 90% can be attained at temperatures up to 50—60°C. Further, changes in the noise characteristics based on the following changes in parameters were studied:

(1) The thickness *d* of the active layer was changed in a range of 0.04—0.07 µm. (2) Among devices which had equal values of $N_D \cdot \Gamma_n$, the laser cavity length *l* was changed in a range of 100—500 µm, and the active layer with *w* was changed in a range of 1—8 µm, whereupon the noise characteristics of the laser devices were investigated. The results were that the devices whose cavity lengths *l* lay within ranges of 210—250 and 400—440 µm were less in the temperature noise and simultaneously higher in the available percentage of low noise devices than the devices whose cavity lengths *l* lay outside the ranges. These results were basicially the same as shown in Figure 5. It was also found that the devices whose active layer widths *w* were smaller were less in the noise and higher in the available percentage of low noise devices. These results were basically the same as shown in Figure 6. It has accordingly been revealed very favorable to set the laser cavity length *l* within the range of 210—250 µm and the active layer width *w* within a range of 1—4 µm under the condition of $N_D \cdot \Gamma_n \geq 500$.

While, in the above, the description has been made by taking as examples a semiconductor laser of the CSP type and a semiconductor laser of the CSP type having a curved active layer, it is needless to say that quite similar results are obtained as to other lasers including a transverse mode index-guided type semiconductor laser, a BH (Buried Heterostructure) laser, a TS (Terraced Substrate) laser, a VSIS laser, and a TJS (Transverse Junction Strip) laser. In addition, the wavelength is not restricted to 780 nm, but similar results have been obtained over the whole range of wavelengths of 680 nm to 890 nm, over which AlGaAs-based lasers are capable of CW oscillations. Besides, the invention is not restricted to lasers fabricated by the liquid epitaxy, but substantially the same results are obtained as to an MBE-grown device having an Sn- or Si-doped clad layer and a device fabricated by as Mo-CVD process and having an Se- or S-doped clad layer. Moreover, the contents of the present invention have been similarly effective in semiconductor laser devices employing laser materials other than AlGaAs, for example, semiconductor laser devices employing group-III—V semiconductor materials such as InGaAsP-based lasers of wavelengths of 1.2—1.6 µm.

Semiconductor laser devices of a single longitudinal mode can be stably provided by applying the present invention.

Figure 10 illustrates the RIN (Relative Intensity Noise) of semiconductor laser devices while comparing an example to which the present invention is applied, with an example to which it is not applied. The results have been obtained under the conditions of an output of 3 mW, a measurement frequency (f) of 2—12 MHz and a measurement bandwidth (Δf) of 300 kHz. The general items of the RIN are detailed in, e.g., a paper by K. Petermann and E. Weidel contained in IEEE, QE-17, No. 7, 1981, p. 1251.

As apparent from the figure, low noise can be maintained at any temperature in accordance with the application of the present invention. In contrast, when the present invention is not applied, noise versus temperature characteristics become very unstable.

**Claims**

1. A semiconductor laser having an optical confinement region formed on a substrate (1) and including a first semiconductor layer (3) sandwiched between second and third semiconductor layers (2, 4), said second and third semiconductor layers (2, 4) having a greater band gap and a lower refractive index than said first semiconductor layer (3) and exhibiting conductivity types opposite to each other, a first electrode formed on the substrate side and a second electrode formed on the semiconductor assembly side having said optical confinement region,

characterized in that the relationship between the donor density $N_D$ given in $10^{17}$ $cm^{-3}$ of that one of said second and third semiconductor layers (2, 4) which is of n-conductivity type, and the proportion $\Gamma_n$

given in % of the optical output of said n-conductivity type semiconductor layer (2) relative to the total optical output of said laser is set at $N_D \times \Gamma_n \geqq 500$.

2. The device of claim 1, wherein the refractive index of said n-conductivity type semiconductor layer (2) is higher than that of the p-conductivity type semiconductor layer (4).

3. The device of claim 1 or 2, wherein the doping impurity of said n-conductivity type semiconductor layer (2) is Te.

**Patentansprüche**

1. Halbleiterlaser mit einem auf einem Substrat (1) ausgebildeten optischen Eingrenzungsbereich, der eine zwischen einer zweiten und einer dritten Halbleiterschicht (2, 4) sandwich-artig angeordnete erste Halbleiterschicht (3) aufweist, wobei die zweite und die dritte Halbleiterschicht (2, 4) einen größeren Bandabstand und einen geringeren Brechungsindex als die erste Halbleiterschicht (3) sowie zueinander entgegengesetzte Leitfähigkeitstypen aufweisen, und wobei auf der Substratseite eine erste Elektrode und auf der Halbleiteranordnungsseite mit dem optischen Eingrenzungsbereich eine zweite Elektrode angeordnet ist,

dadurch gekennzeichnet, daß die Beziehung zwischen der in $10^{17}$ $cm^{-3}$ angegebenen Donatordichte ($N_D$) derjenigen der zweiten und dritten Halbleiterschichten (2, 4), die den n-Leitfähigkeitstyp aufweist, und den in % angegebenen Anteil $\Gamma_n$ der optischen Ausgangsleistung der Halbleiterschicht (2) des n-Leitfähigkeitstyps, bezogen auf die gesamte optische Ausgangsleistung des Lasers, mit $N_D \times \Gamma_n \geqq 500$ gewählt ist.

2. Vorrichtung nach Anspruch 1, wobei der Brechungsindex der Halbleiterschicht (2) das n-Leitfähigkeitstyps größer ist als derjenige der Halbleiterschicht (4) des p-Leitfähigkeitstyps.

3. Vorrichtung nach Anspruch 1 oder 2, wobei der Dotierstoff der Halbleiterschicht (2) des n-Leitfähigkeitstyps Te ist.

**Revendications**

1. Laser à semiconducteurs comportant une région de confinement optique formée sur un substrat (1) et incluant une première couche semiconductrice (3) enserrée entre des seconde et troisième couches semiconductrices (2, 4), lesdites seconde et troisième couches semiconductrices (2, 4) possédant une bande interdite plus large et un indice de réfraction plus faible que la bande interdite et l'indice de réfraction de ladite première couche semiconductrice (3) et présentant des types de conductivité opposés l'un à l'autre, une première électrode formée sur le côté du substrat et une seconde électrode formée sur le côté de l'ensemble semiconducteur, comportant ladite région de confinement optique,

caractérisé en ce que la relation entre la densité ($N_D$) des donneurs, indiquée en $10^{17}$ $cm^{-3}$, de celle desdites seconde et troisième régions semiconductrices (2, 4), qui possède le type de conductivité n, et la proportion $\Gamma_n$, indiquée en %, de la puissance de sortie optique de ladite couche semiconductrice (2) possédant le type de conductivité n, par rapport à la puissance de sortie optique totale dudit laser est réglée de manière que l'on mit $M_D \times \Gamma_n \geqq 500$.

2. Dispositif selon la revendication 1, dans lequel l'indice de réfraction de ladite couche semiconductrice (2) possédant le type de conductivité n est supérieur à celui de la couche semiconductrice (4) possédant le type de conductivité p.

3. Dispositif selon la revendication 1 ou 2, dans lequel l'impureté de dopage de ladite couche semiconductrice (2) possédant le type de conductivité n est de Te.

FIG. 1

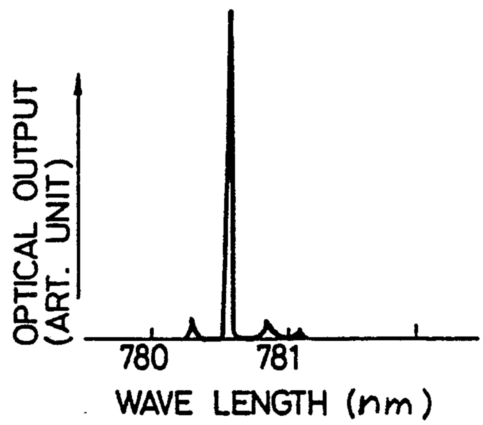


FIG. 2

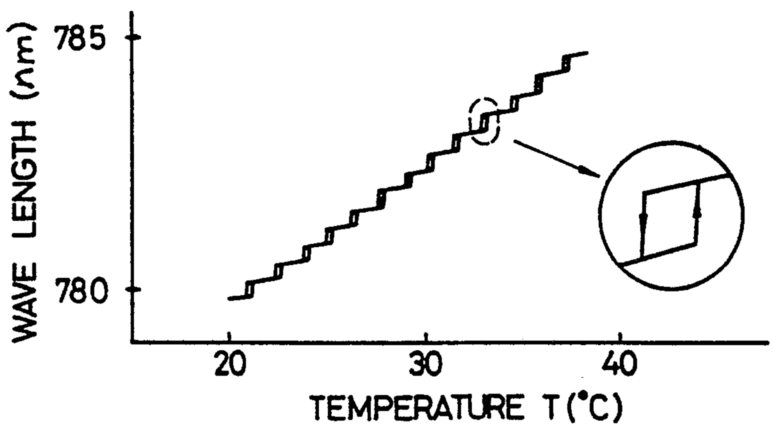


FIG. 3

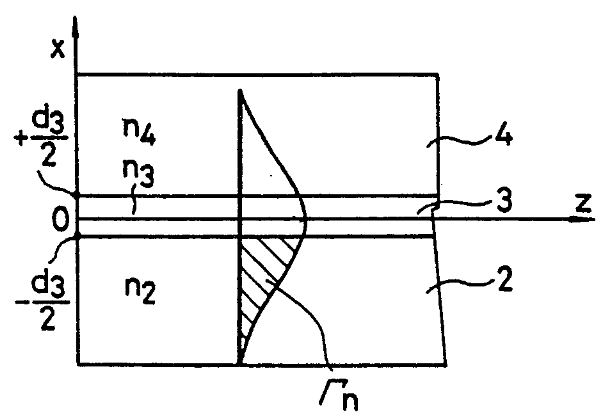

FIG. 4

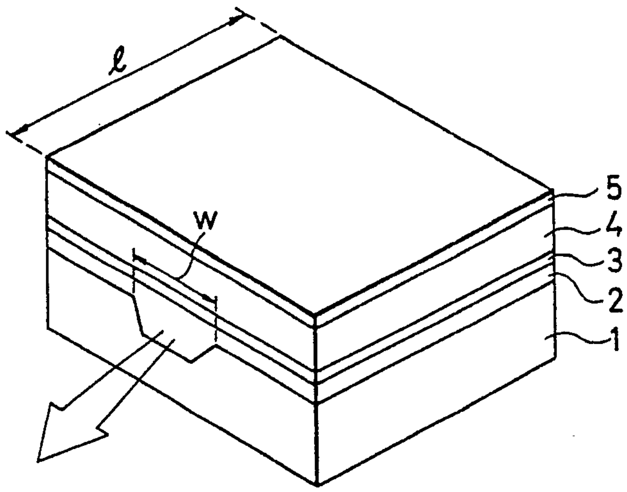
ℓ
w
5
4
3
2
1

FIG. 6

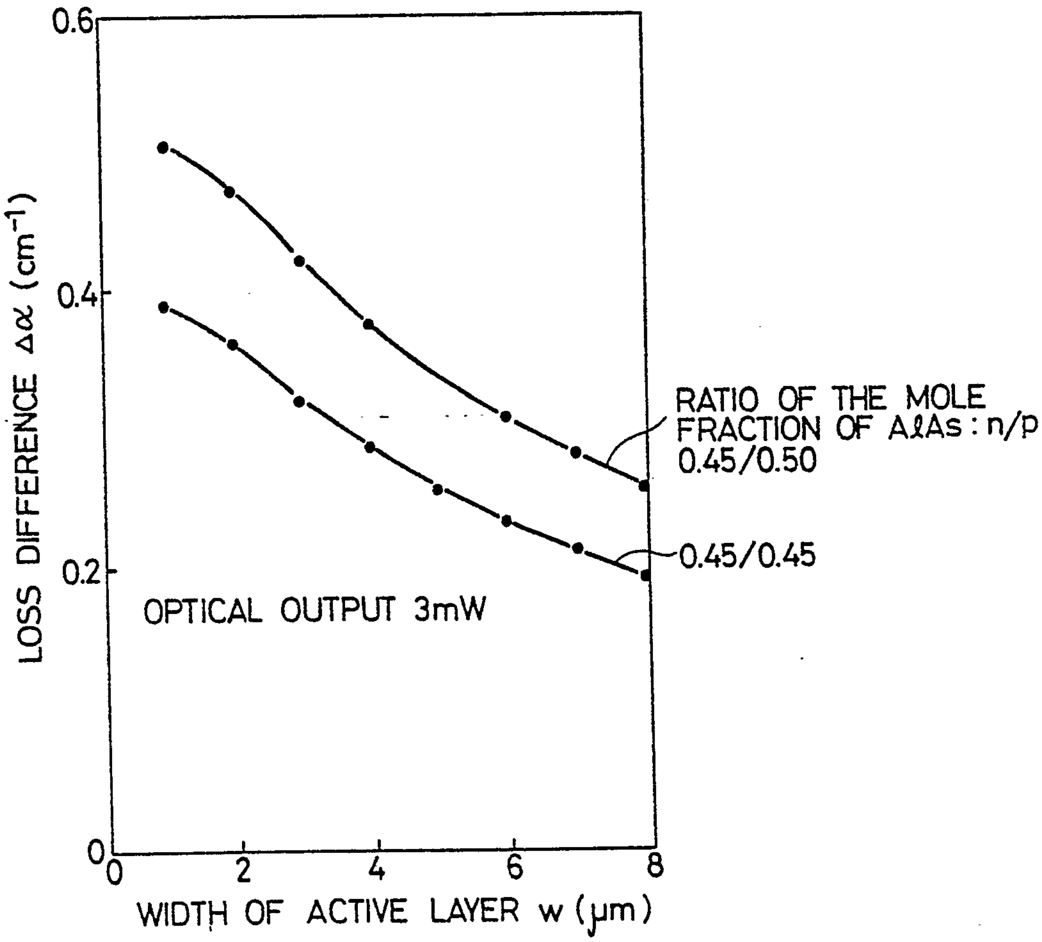
0.6
0.4
0.2
0
LOSS DIFFERENCE Δα (cm⁻¹)
0
2
4
6
8
WIDTH OF ACTIVE LAYER w (μm)
OPTICAL OUTPUT 3mW
RATIO OF THE MOLE FRACTION OF AℓAs : n/p
0.45/0.50
0.45/0.45

FIG. 5

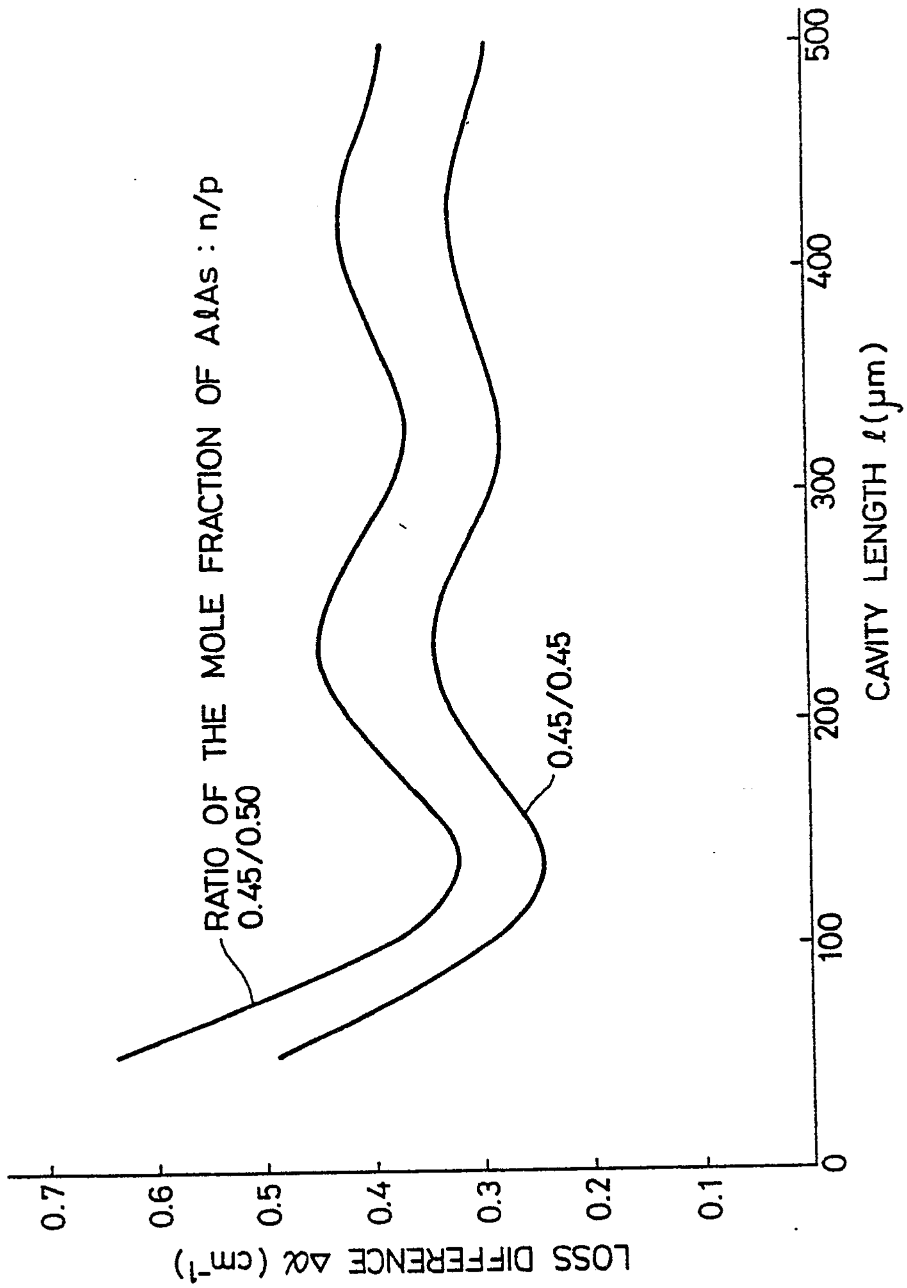
RATIO OF THE MOLE FRACTION OF AlAs : n/p
0.45/0.50
0.45/0.45
LOSS DIFFERENCE Δα (cm⁻¹)
0.7
0.6
0.5
0.4
0.3
0.2
0.1
0
100
200
300
400
500
CAVITY LENGTH ℓ (μm)

FIG. 7

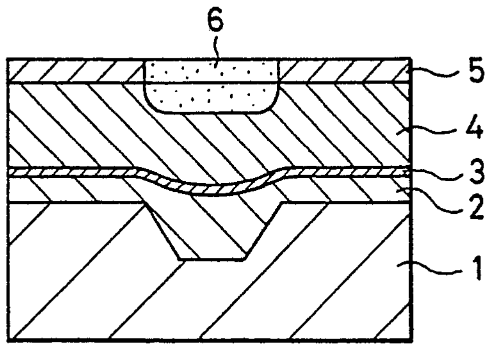
6
5
4
3
2
1

FIG. 8

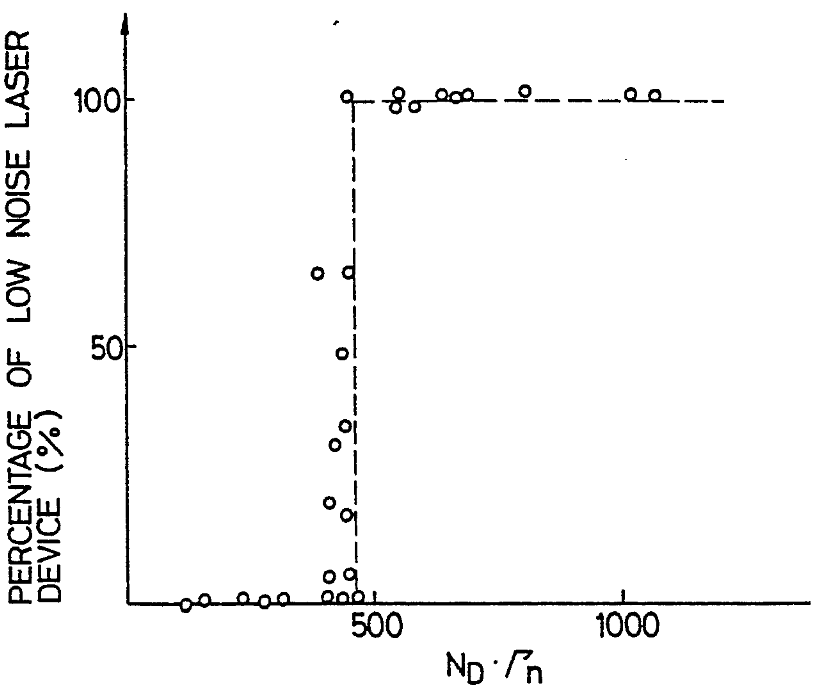
PERCENTAGE OF LOW NOISE LASER DEVICE (%)
100
50
500
1000
$N_D \cdot \Gamma_n$

FIG. 9

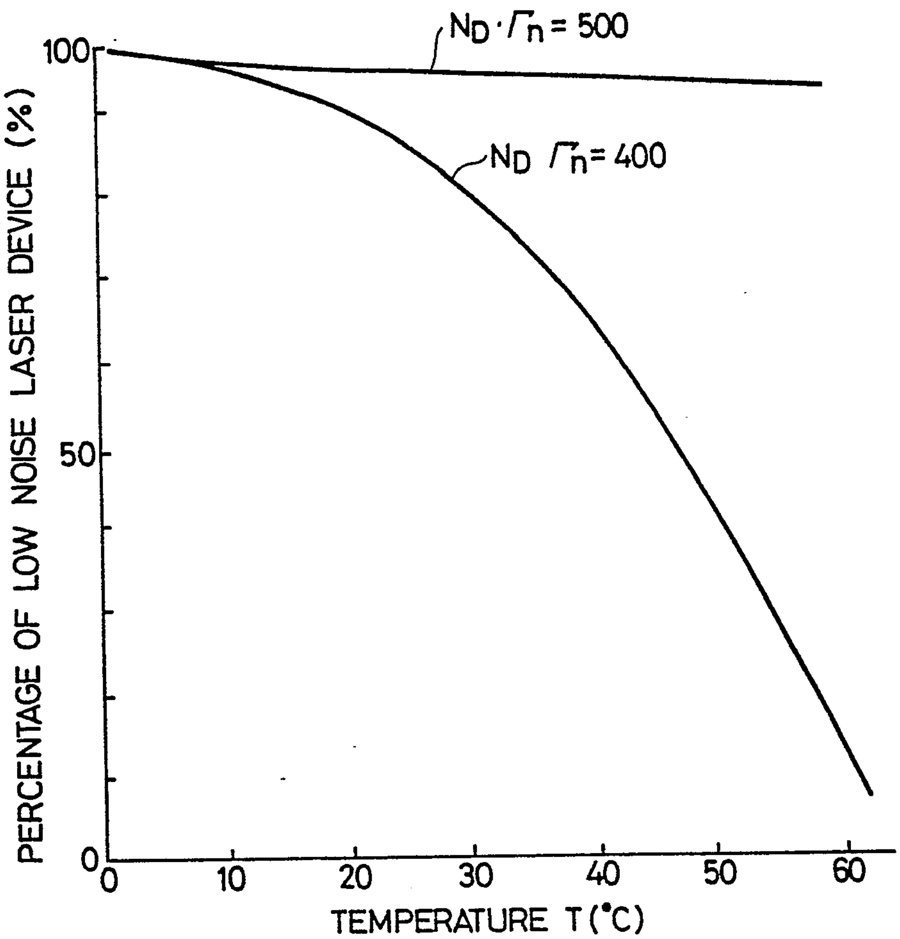
$N_D \cdot \Gamma_n = 500$
$N_D \Gamma_n = 400$
100
50
0
PERCENTAGE OF LOW NOISE LASER DEVICE (%)
0
10
20
30
40
50
60
TEMPERATURE T (°C)

FIG. 10

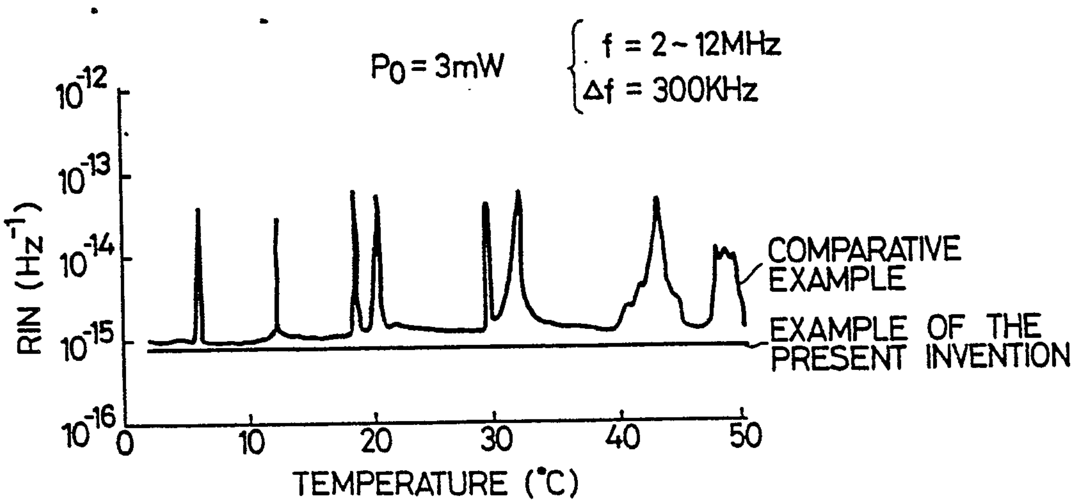
$P_0 = 3mW$
f = 2 ~ 12MHz
Δf = 300KHz
$10^{-12}$
$10^{-13}$
$10^{-14}$
$10^{-15}$
$10^{-16}$
RIN ($Hz^{-1}$)
COMPARATIVE EXAMPLE
EXAMPLE OF THE PRESENT INVENTION
0
10
20
30
40
50
TEMPERATURE (°C)